# EUROPÄISCHE PATENTSCHRIFT

(11) **EP 1 079 220 B1**
(45) Veröffentlichungstag und Bekanntmachung des Hinweises auf die Patenterteilung: **23.01.2008**
(21) Anmeldenummer: 00113622.5
(22) Anmeldetag: 28.06.2000
(51) Int. Cl.: G01L 9/00

(54) **Mikromechanischer Sensor und Verfahren zur hermetischen Verkapselung**
Micromechanical sensor and method for hermetic sealing
Détecteur microméchanique et méthode de scellement hermétique

(30) Priorität: 12.08.1999 DE 19938207
(43) Veröffentlichungstag der Anmeldung: 28.02.2001
(73) Patentinhaber: ROBERT BOSCH GMBH, 70442 Stuttgart (DE)
(72) Erfinder: Walter, Marc, 73479 Ellwangen (DE); Pinter, Stefan, 72762 Reutlingen (DE); Emmerich, Harald, 72760 Reutlingen (DE); Baumann, Helmut, 72810 Gormaringen (DE)

(56) Entgegenhaltungen:
- US-A- 5 637 801
- US-A- 5 721 446
- PATENT ABSTRACTS OF JAPAN vol. 015, no. 230 (P-1214), 12. Juni 1991 (1991-06-12) & JP 03 071030 A (NEC CORP), 26. März 1991 (1991-03-26)

## Beschreibung

Die Erfindung betrifft einen Sensor, insbesondere einen mikromechanischen Sensor, mit einem Sensorelement, an dem ein Deckelelement mittels eines Verbindungsmittels unter hermetischem Abschluß befestigt ist, wobei wenigstens eines der zwei Elemente eine zum anderen Element offene Vertiefung aufweist, die von einem Verbindungsbereich umgeben ist, wobei die zwei Elemente im Verbindungsbereich unter Ausbildung eines Spalts einander gegenüberliegen, in welchem das Verbindungsmittel angeordnet ist, entsprechend dem einleitenden Teil des Anspruchs 1.

Ferner bezieht sich die Erfindung auf ein Verfahren zur Herstellung eines Sensors, gemäß welchem ein Sensorelement und ein Deckelelement hergestellt werden, wobei wenigstens eines der zwei Elemente eine Vertiefung aufweist, die von einem Verbindungsbereich umgeben ist, und wobei auf dem Verbindungsbereich wenigstens einer der zwei Elemente ein Verbindungsmittel aufgetragen wird, und das Deckelelement gegenüber dem Sensorelement derart positioniert wird, daß sich im Verbindungsbereich zwischen den zwei Elementen ein die Vertiefung umgebender Spalt bildet, in welchem ein Verbindungsmittel angeordnet wird, und anschließend ein gegenseitiges Annähern der zwei Elemente erfolgt, so daß sich das Verbindungsmittel im Spalt ausbreitet, gemäß dem Oberbegriff des Anspruchs 10.

### Stand der Technik

Mikromechanische Sensoren, wie zum Beispiel oberflächenmikromechanische (OMM) Sensoren, werden in bekannter Weise mit Hilfe eines Verbindungsmittels, wie zum Beispiel Glaslot (Sealglas), unter hermetischem Abschluß verkapselt. Bei einem derartigen, auch als Sealglasbonden bekannten Verfahren wird ein mit wenigstens einem Sensormittel versehenes Sensorelement mit einem unter Ausbildung eines Spaltes gegenüberliegenden Deckelelement durch das im Spalt angeordnete Glaslot unter hermetischem Abschluß verbunden. Das Glaslot kann in bekannter Weise per Siebdruckverfahren vorzugsweise auf dem Deckelelement aufgebracht und anschließend in einem als Prebake-Prozeß bezeichneten Ofenprozeß gesintert werden. Das Deckelelement kann mit einer Vertiefung versehen sein, welche bei montiertem Sensor gegenüber dem Sensormittel angeordnet ist. Derartige mikromechanische Sensoren erfordern zur Erzielung einer hohen Güte, das heißt einer geringen Dämpfung der mechanischen Schwingungsstruktur durch ein umgebendes Medium, einen möglichst geringen Gasdruck im unter hermetischem Abschluß verkapselten Sensorinnenraum. Deshalb werden derartige Sensoren unter Vakuum verkapselt.

Bei einer herkömmlichen Verkapselung unter Verwendung von Sealglas als Verbindungsmittel läßt sich durch Gasdruckverringerung nachteilhafterweise kein Gasdruck unter 10 mbar im Sensorinnenraum erzielen. Dies beruht insbesondere auf der Tatsache, daß sich während des auf einer gegenseitigen Annäherungsbewegung der zwei Elemente basierenden und eine Kompressionsbeanspruchung des sich im Spalt befindenden Sealglases hervorrufenden Verbindungsprozesses unter Vakuum im Sealglas Gasblasen bilden, welche auf gasförmige Zersetzungsprodukte der organischen Bestandteile, wie zum Beispiel Siebdruckpastenbestandteile, im Sealglas zurückzuführen sind. Der Gasdruck im Sensorinnern erhöht sich, wenn sich die Gasblasen des Sealglases während beziehungsweise nach der Verbindung der beiden Elemente auf der zum Sensorinnenraum hin gerichteten freien Oberfläche des Sealglases öffnen.

Somit hängt die Gasdruckerhöhung im Sensorinnenraum von der Größe der Ausgasungsfläche des Sealglases im Sensorinnern ab. Durch die aufgrund der gegenseitigen Annäherung des Deckelelements und des Sensorelements erfolgende Kompressionsbeanspruchung des sich im Spalt befindenden Sealglases breitet sich das Sealglas gleichmäßig im Spalt aus. Dabei kommt es zu wulstförmigen Ausbildungen von überschüssigem Sealglas am zum Sensorinnern gerichteten Spaltende. Aufgrund der bei normaler Sealglasmenge sich ergebenden Vergrößerung der ausgasenden, zum Sensorinnern gerichteten Oberfläche eines Sealgläswulstes in bezug auf eine freie, mehr oder weniger ebene und sich im Spalt ausbildende Sealglasoberfläche kommt es im Sensorinnern zu einer unerwünscht hohen Druckerhöhung aufgrund von sich öffnenden Gasblasen auf der ausgasenden Sealglasoberfläche. Andererseits führt eine zu starke Reduzierung der Sealglasmenge zu einer derartigen Verkleinerung der effektiven Sealglasschichtdicke im Spalt, daß eine Verbindung des Sensorelements mit dem Deckelelement unter hermetischem Abschluß aufgrund der Gefahr von unzureichend mit Sealglas ausgefülltem Spaltvolumen nicht garantiert werden kann.

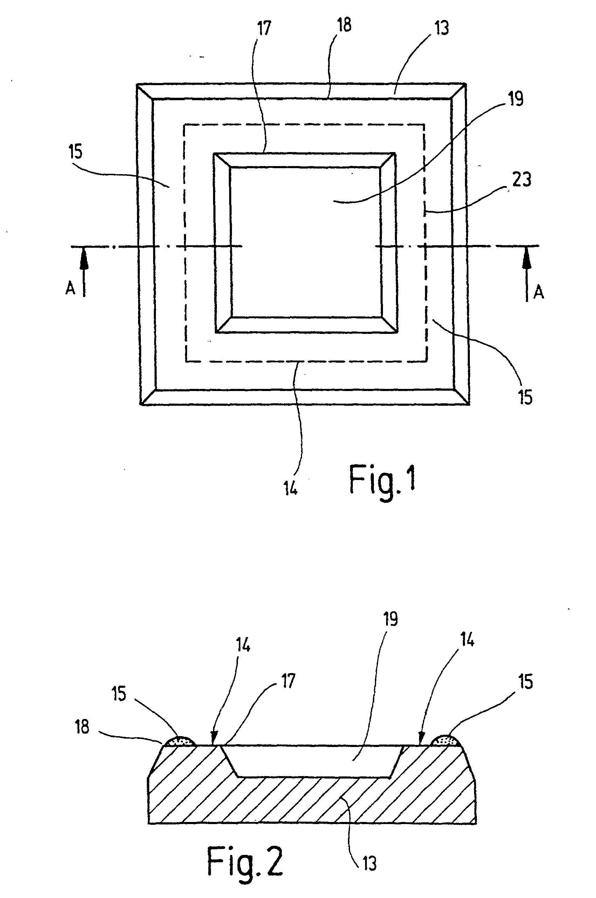

Die Schrift JP 03071030 offenbart ein Verfahren zum Aufkleben eines Drucksensor-Chips auf einem Verpackungselement, bei dem Nuten in das Verpackungselement eingebracht werden, deren Anordnung der umfänglichen Außenkontur des Drucksensor-Chips beziehungsweise einer Mittellinie eines Verbindungsbereichs entsprechen und Kleber in die Nuten gefüllt wird, wobei ein Teil des Klebers gegenüber der Oberfläche des Verpackungselements aus der Nut herausragt. Beim anschließenden Annähern des Drucksensor-Chips an das Verpackungselement wird der Drucksensor-Chip mit seinem Verbindungsbereich gegen den herausragenden Teil des Klebers gedrückt, wobei der Kleber aufgrund von Kapillarwirkung in den entstehenden Spalt hineingezogen wird. Die Nuten dienen bei dem Verkleben des Drucksensor-Chips auf dem Verpackungselement somit als Vorratsbehälter/Quelle für den Kleber und sind auf der Mittellinie oder in Bezug auf die Mittellinie von der Vertiefung weg versetzt angeordnet (siehe Figuren 1 bis 4).

### Vorteile der Erfindung

Der erfindungsgemäße Sensor ist dadurch gekennzeichnet, daß vor dem Verbinden der beiden Elemente das Verbindungsmittel derart auf dem Verbindungsbereich mindestens eines der Elemente aufgetragen wurde, daß es in bezug auf eine Mittellinie des Verbindungsbereichs von der Vertiefung weg versetzt liegt und daß ein die Höhe des Spalts bestimmender Abstand der beiden Elemente durch deren Annähern derart eingestellt wird, daß das sich im Spalt zur Vertiefung hin durch Kompression ausbreitende Verbindungsmittel vom Spaltvolumen vollständig aufgenommen wird. Der Sensor mit den im Anspruch 1 genannten Merkmalen bietet den Vorteil, daß das vor der hermetisch dichten Verbindung der zwei Elemente asymmetrisch zur Außenseite des Verbindungsbereichs hin angeordnete Verbindungsmittel sich während einer Kompressionsbeanspruchung derart im Spalt ausbreitet, daß es unter definierten Befestigungsparametern nicht die zur Vertiefung gerichtete Innenseite des Verbindungsbereichs erreicht und es somit zu keiner ausgasungssteigernden, wölbungsförmigen Oberflächenvergrößerung der in das Sensorinnere gerichteten freien Verbindungsmittel-oberfläche kommt. Dadurch wird die Ausgasungsfläche des Verbindungsmittels im Sensor auf ein Minimum reduziert, da die sich in einem Spalt ausbildende, mehr oder weniger ebene Ausgasungsfläche kleiner ist als ein tropfen- beziehungsweise wulstartig ausgebildetes Verbindungsmittel im Sensorinnern. Die nicht erwünschten Druckerhöhungen im vakuumverkapselten Sensorinnern aufgrund von sich öffnenden Gasblasen auf der freien, zum Sensorinnenraum hin gerichteten Ausgasungsfläche des Verbindungsmittels sind somit vorteilhafterweise geringer als bei traditionellen Sensoren.

Das Verbindungsmittel ist vorzugsweise auf dem Verbindungsbereich des Deckelelements angeordnet. Da im Gegensatz zum Sensorelement das Deckelelement nicht mit sensiblen Sensormitteln versehen ist, eignet es sich besonders zur Anordnung des Verbindungsmittels auf dem Verbindungsbereich.

Vorteilhafterweise weist der Verbindungsbereich eine Verbindungsmittel-Aufnahmestruktur auf. Durch die geometrische Aufnahmestruktur eines Aufnahmeabschnittes ist der Verbindungsbereich geeignet, ein Ausbreiten des überschüssigen Verbindungsmittels in die Vertiefung während einer Kompressionsbeanspruchung zu verhindern und somit die unerwünschte Ausbildung eines Wulstes des Verbindungsmittels im Sensorinneren auszuschließen.

Gemäß einer bevorzugten Ausführungsform ist die Verbindungsmittel-Aufnahmestruktur als mindestens eine Ausnehmung, insbesondere Aufnahmenut, ausgebildet. Eine Aufnahmenut ist besonders geeignet, eine möglichst große Masse an sich während einer Kompressionsbeanspruchung zur Vertiefung hin ausbreitendem Verbindungsmittel aufzunehmen.

Die Ausnehmung verläuft wenigstens bereichsweise parallel oder etwa parallel zum Rand der Vertiefung. Dadurch wird in effektiver Weise ein Eintreten von überschüssigem Verbindungsmittel in die Vertiefung vermieden.

In bevorzugter Weise ist die Ausnehmung im Querschnitt V-förmig ausgebildet. Eine derartig geometrisch ausgebildete Ausnehmung ist in einfacher Weise unter gleichzeitig erhöhten Präzisionsanforderungen herstellbar.

Vorzugsweise sind mindestens zwei parallele Ausnehmungen vorgesehen, so daß eine höhere Sicherheit in bezug auf eine nicht erwünschte Wulstbildung des Verbindungsmittels im Sensorinnenraum erzielt wird.

Vorteilhafterweise ist das Verbindungsmittel als Glaslot ausgebildet. Glaslot läßt sich in verhältnismäßig einfacher Weise per Siebdruckverfahren auf dem Deckelelement aufbringen und anschließend in einem Ofenprozeß (Prebake-Prozeß) sintern. Ferner läßt sich Sealglas beim Verbindungsprozeß (Bondprozeß) der zwei Elemente vorteilhafterweise leicht aufschmelzen.

Gemäß einer bevorzugten Ausführungsform liegt zur Maximierung des Volumens der Vertiefung eine Minimalwandstärke des Deckelelements im Bereich der Vertiefung vor. Durch die erwünschte Vergrößerung des Vertiefungsvolumens wirkt sich nach dem idealen Gasgesetz (P1 x V1 = P2 x V2) eine eventuelle Druckkerhöhung im Sensorinnern anteilsmäßig geringer und somit weniger nachteilhaft auf die Sensorgüte aus. Es können vorteilhafterweise die Sensoraußenabmessungen bei Vergrößerung des Vertiefungsvolumens unverändert bleiben.

Weitere vorteilhafte Ausgestaltungen der Erfindung ergeben sich aus der Beschreibung.

### Zeichnungen

Die Erfindung wird nachfolgend in mehreren Ausführungsbeispielen anhand zugehöriger Zeichnungen näher erläutert. Es zeigen:
- Figur 1: eine schematische Draufsicht eines erfindungsgemäßen Deckelelements;
- Figur 2: einen schematischen Querschnitt entlang der Linie A-A gemäß Figur 1;
- Figur 3: eine schematische Draufsicht auf eine weitere Ausführungsform eines erfindungs-gemäßen Deckelelements;
- Figur 4: einen schematischen Querschnitt entlang der Linie B-B gemäß Figur 3 und
- Figur 5: eine schematische Seitenansicht eines geschnittenen Sensors mit einem Deckelelements gemäß Figur 4.

### Beschreibung der Erfindung

Unter Bezugnahme auf die Figuren 1 und 2 ist ein Deckelelement 13 dargestellt. Das Deckelelement 13 ist mit einer zentralen Vertiefung 19 versehen, die von einem umfangsförmig geschlossenen, rahmenartigen Verbindungsbereich 14 umgeben ist. Das Deckelelement 13 ist gemäß der Draufsicht nach Figur 1 rechteckig ausgebildet. Entsprechend einer alternativen Ausführungsform kann das Deckel-element 13 auch eine andere, beispielsweise eine runde Außen-und/oder Innenkontur aufweisen. Die zentrale Vertiefung 19 ist zum Verbindungsbereich hin randoffen ausgebildet. Auf dem Verbindungsbereich 14 ist ein raupenförmig aufgetragendes und umfangsförmig sich um die zentrale Vertiefung 19 erstreckendes Verbindungsmittel 15 vorgesehen. Der rahmenartige Verbindungsbereich 14 ist durch einen inneren, an die Vertiefung 19 angrenzenden Rand 17 und durch einen äußeren, an eine entsprechende Sensoraußenseite angrenzenden Rand 18 bestimmt. Der innere Rand 17 erstreckt sich in bezug auf den äußeren Rand 18 parallel um die rechteckig ausgebildete Vertiefung 19.

Das Verbindungsmittel 15 ist derart auf dem Verbindungsbereich 14 des Deckelelements 13 aufgetragen worden, daß es in bezug auf eine Mittellinie 23 des Verbindungsbereiches 14 von der Vertiefung 19 weg versetzt liegt. Das Verbindungsmittel 15 ist somit in bezug auf die Mittellinie 23 des Verbindungsbereichs 14 des Deckelelements 13 asymmetrisch zum äußeren Rand 18 hin angeordnet.

Entsprechend Figur 2 ist das Verbindungsmittel 15 auf einem Oberflächensektor des Verbindungsbereichs 14 des Deckelelements 13 aufgetragen, welcher durch die Mittellinie 23 und den äußeren Rand 18 begrenzt ist. Entsprechend einer alternativen Ausführungsform kann das Verbindungsmittel 15 auch auf einem Oberflächensektor des Verbindungsbereichs 14 angeordnet sein, welcher in bezug auf den äußeren Rand 18 abstandbehaftet ist und gleichzeitig in bezug auf die Mittellinie 23 des Verbindungsbereichs 14 von der Vertiefung 19 weg versetzt liegt.

Das Verbindungsmittel 15 ist vorzugsweise als Glaslot beziehungsweise Sealglas ausgebildet, welches zur Herstellung eines hermetischen Abschlusses im Verbindungsbereich 14 des Deckelelements 13 mit einem unter Ausbildung eines Spalts gegenüber angeordneten Sensorelements geeignet ist.

Das vorzugsweise unter Vakuum stattfindende Verbinden unter hermetischem Abschluß des Deckelelements 13 mit einem Sensorelement, was auch als Vakuumverkappen bezeichnet wird, erfolgt folgendermaßen: Das wenigstens ein Sensormittel aufweisende Sensorelement wird gegenüber dem Deckelelement 13 derart angeordnet, daß im Verbindungsbereich 14 zwischen den zwei Elementen ein Spalt ausgebildet wird, in welchem das Verbindungsmittel 15 auf dem Verbindungsbereich 14 des Deckelelements 13 zunächst unverändert angeordnet ist. Durch eine kontrollierte gegenseitige Annäherung der zwei gegenüberliegenden Elemente ergibt sich eine Kompressionsbeanspruchung des sich im Spalt befindenden Verbindungsmittels 15, welche ein Ausbreiten des Verbindungsmittel 15 im Spalt in Richtung inneren Rand 17 und äußeren Rand 18 verursacht. Die kontrollierte Annäherung der zwei Elemente erfolgt derart, daß das sich im Spalt zur Vertiefung 19 hin durch Kompression ausbreitende Verbindungsmittel 15 vom Spaltvolumen vollständig aufgenommen wird. Dadurch wird eine sich nachteilig auf die Sensorgüte auswirkende Wulstbildung am inneren Rand 17 des Verbindungsbereiches 14 vermieden. Die zur Vertiefung 19 gerichtete, ausgasende Oberfläche des Verbindungsmittels 15 ist vorteilhafterweise als mehr oder weniger ebene, sich in einem Spalt ausbildende Oberfläche einer kontinuierlichen Verbindungsmittelschicht ausgebildet. Ein eventuell sich bildender Wulst am zur Sensoraußenseite gerichteten, äußeren Rand des Deckelelements 13 wirkt sich nicht nachteilig auf die Sensorgüte aus, da dessen Ausgasungsfläche keinen Einfluß auf das Druckniveau im hermetisch abgeschlossenen Sensorinnenraum hat.

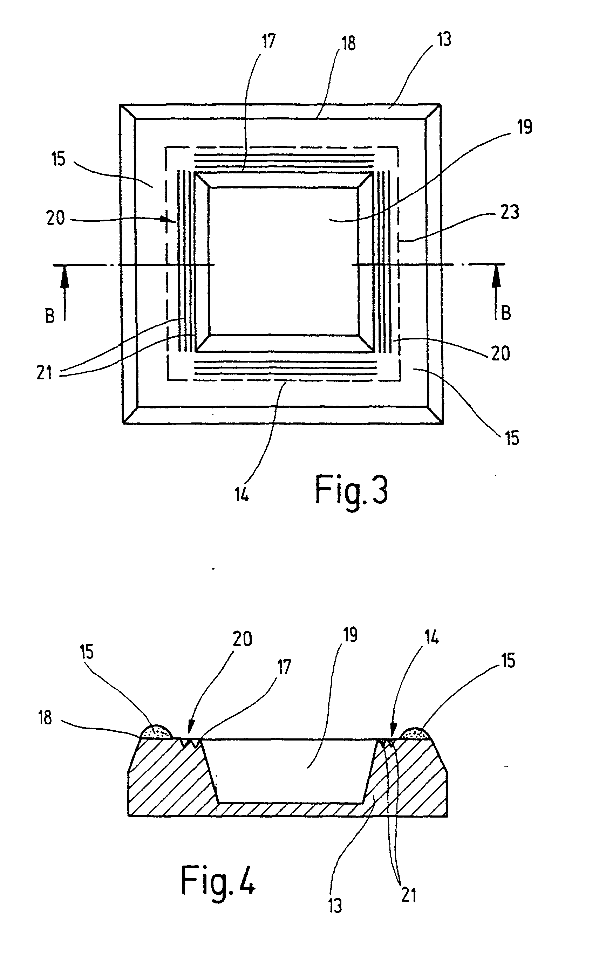

Unter Bezugnahme auf die Figuren 3 und 4 ist eine weitere Ausführungsform des Deckelelements 13 dargestellt. Das Deckelelement 13 ist mit einer sich zum inneren Rand 17 parallel erstreckenden Aufnahmestruktur 20 für das sich während der Kompressionsbeanspruchung zum inneren Rand 17 hin ausbreitende Verbindungsmittel 15 versehen. Die Aufnahmestruktur 20 für das Verbindungsmittel 15 ist als Aufnahmenut 21 ausgebildet. Im vorliegenden Ausführungsbeispiel gemäß Figur 3 sind jeweils zwei sowohl zueinander als auch in bezug auf den inneren Rand 17 parallele, im Querschnitt V-förmig ausgebildete, zu jedem der vier die rechteckige Vertiefung 19 umfangsförmig umschließenden, geradlinigen Unterabschnitte des inneren Randes 17 benachbarte Aufnahmenuten 21 vorgesehen. Die zueinander im rechten Winkel stehenden Aufnahmenuten 21 sind nicht miteinander verbunden, sondern enden als sich jeweils linear erstreckende, voneinander getrennte Nuten. Derartig ausgebildete Aufnahmenuten 21 sind fertigungstechnisch einfach und schnell herstellbar. Gemäß einer alternativen Ausführungsform können die vier Innen- und Außennuten 21 jeweils als eine rechteckig sich erstreckende, O-förmige innere und äußere Umlaufnut ausgebildet sein. In dieser Weise erhält man eine kontinuierliche, ununterbrochene und in Ausdehnungsrichtung des Verbindungsmittels 15 gesehen zweifach wirkende und deshalb sehr effektive Aufnahmestruktur 20.

Anstatt einer V-förmigen, kontinuierlichen Aufnahmenut 21 sind auch eine oder mehrere Ausnehmungen unterschiedlicher geometrischer Ausgestaltungen zur Bildung einer Aufnahmestruktur für das während der Kompressionsbeanspruchung zum inneren Rand 17 sich ausbreitende Verbindungsmittel 15 denkbar. Auch diese Ausnehmungen verlaufen vorzugsweise einzeln, und/oder in einer Untergruppe zusammengefaßt, zu-mindest bereichsweise parallel oder etwa parallel in bezug auf den die rechteckige beziehungsweise quadratische Vertiefung 19 umlaufenden, inneren Rand 17. Wie in den Figuren 3 und 4 zu erkennen ist, erstreckt sich die Verbindungsmittel-Aufnahmestruktur entlang eines inneren Oberflächen-sektors des Verbindungsbereiches 14 des Deckelelements 13. Der innere Oberflächensektor erstreckt sich vorzugsweise auf dem Verbindungsbereich 14 von der Mittellinie 23 ausgehend bis zum inneren Rand 17. Auf dem verbleibenden äußeren Oberflächensektor, das heißt der Bereich zwischen der Mittellinie 23 und dem äußeren Rand 18 auf dem Verbindungsbereich 14, ist das Verbindungsmittel 15 raupenartig aufgetragen.

Erfindungsgemäß ist vorgesehen, daß zur Maximierung des Volumens der Vertiefung 19 eine minimale Wandstärke des Deckelelements 13 im Bereich der Vertiefung 19 vorliegt. Durch eine derartige Reduzierung der Wandstärke des Deckelelements 13 im Bereich der Vertiefung 19 ergibt sich eine in bezug auf die in Figur 2 dargestellte Ausführungsform vorteilhafte Volumenvergrößerung der Vertiefung 19. Eine zusätzliche Volumenvergrößerung läßt sich ferner über eine als Hinterschneidung der Verbindungsmittel-Aufnahmestruktur ausgebildete Ausnehmung im Körper des Deckelelements 13 erreichen. Bei der Minimierung der Wandstärke des Deckelelements 13 ist zu beachten, daß das Deckelelement 13 eine zur Vakuumverkapselung mit einem Sensorelement ausreichende Stabilität besitzt und daß eine korrekte Funktionsweise eines mit einem derartigen Deckelelement 13 versehenen Sensors gewährleistet ist.

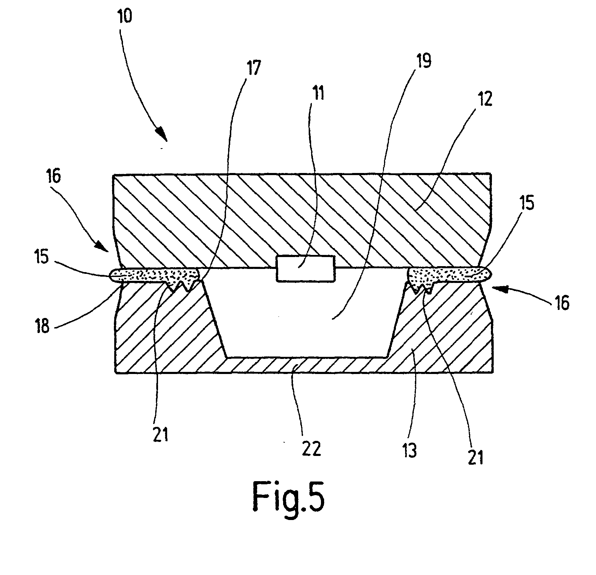

Zur Herstelung eines Sensors gemäß Figur 5 wird beim Verkappungsprozeß ein entsprechend Figur 4 ausgebildetes Deckelelement 13 gegenüber einem ein Sensormittel 11 aufweisendes Sensorelement 12 in solcher Weise positioniert, daß sich die Verbindungsbereiche 14 der beiden Elemente 12, 13 unter Bildung eines Spalts gegenüberstehen. Die beiden Elemente 12, 13 werden in bekannter und kontrollierter Weise aufeinanderzubewegt, so daß sich die Spalthöhe im Verbindungsbereich 14 verkleinert und das auf dem äußeren Oberflächensektor des Verbindungsbereichs 14 des Deckelelements 13 raupenartig angeordnete Verbindungsmittel 15 kompressiv durch die gegenüberliegende, in bezug auf das Deckelelement 13 sich nähernde Oberfläche des Verbindungsbereichs 14 des Sensorelements 12 beansprucht wird. Durch diese Kompressionsbeanspruchung bewegt sich wenigstens ein Teil des Verbindungsmittels 15, das in bezug auf die Mittellinie 23 des Verbindungsbereichs 14 von der Vertiefung 19 weg versetzt angeordnet ist, in Richtung innerer Rand 17 und ein anderer Teil des Verbindungsmittels 15 in Richtung äußerer Rand 18 beziehungsweise über diesen äußeren Rand 18 hinaus unter Bildung eines Verbindungsmittelwulstes. Die mit den Aufnahmenuten 21 versehene Verbindungsmittel-Aufnahmestruktur 20 dient als Aufnahmespeicher des sich zum inneren Rand 17 hin ausbreitenden Verbindungsmittels 15 während der Kompressionsbeanspruchung, so daß bei kontrollierter Annäherung der beiden Elemente 12, 13 unter definierten Verfahrensparametern eine unerwünschte Wulstbildung des Verbindungsmittels 15 am inneren Rand 17 beziehungsweise in der Vertiefung 19 in besonders einfacher und zuverlässiger Weise verhindert wird. Der die Höhe des Spalts bestimmende Abstand der beiden Elemente 12, 13 wird durch deren Annähern derart hergestellt, daß das sich im Spalt zur Vertiefung 19 hin durch Kompression ausbreitende Verbindungsmittel 15 vom Spaltvolumen vollständig aufgenommen wird.

Eine wie in Figur 5 dargestellte Wulstbildung des Verbindungsmittels 15 an der Sensoraußenseite 16 wirkt sich nicht nachteilhaft auf die Sensorgüte aus, da die Ausgasungsfläche eines derartigen, äußeren Wulstes keinen Einfluß auf den Gasdruck im Sensorinnern ausübt.

Die zum Sensorinnenraum gerichtete ausgasende Oberfläche des Verbindungsmittels 15 ist auf ein Minimum reduziert, so daß es zu einer geringeren Drukkerhöhung im Sensorinnenraum aufgrund von sich öffnenden Gasblasen an der Verbindungsmitteloberfläche während beziehungsweise nach der Vakuumverkapselung des Sensors 10 kommen kann.

Wie in Figur 5 dargestellt, ist das Sensorinnenvolumen durch eine Reduzierung der Wandstärke des Vertiefungsbodens 22 maximiert worden, um auf diese Weise Druckänderungen im Sensorinnern aufgrund von sich öffnenden Gasblasen auf der Innenoberfläche des Verbindungsmittels 15 so gering wie möglich zu halten, da nach dem idealen Gasgesetz (P1 x VI = P2 x V2) eine Druckerhöhung in der Vertiefung 19 umso kleiner ausfällt, je größer das Volumen der Vertiefung 19 ausgebildet ist.

Es können eine oder gleichzeitig mehrere der oben beschriebenen Maßnahmen zur Verhinderung beziehungsweise Reduzierung einer Druckerhöhung im Sensorinnenraum während beziehungsweise nach der Vakuumverkapselung des Sensors 10 herangezogen werden, um in einfacher und effektiver Weise eine Güteverbesserung des Sensors 10 in bezug auf traditionelle Sensoren zu erzielen.

Die Erfindung beschränkt sich in ihrer Anwendung selbstverständlich nicht auf die dargestellten Ausführungsbeispiele. So kann beispielsweise auch das Sensorelement 12 mit einer oder mehreren, das Volumen des Sensorinnenraums vergrößerende Ausnehmungen beziehungsweise Vertiefungen versehen sein. Ferner kann das Verbindungsmittel 15 vor dem Verkappungsprozeß in entsprechender Weise auf einem äußeren Oberflächensektor des Verbindungsbereichs 14 des Sensorelements 12 aufgebracht sein. Auch kann die Verbindungsmittel-Aufnahmestruktur in entsprechender Weise auf einem inneren Oberflächensektor des Verbindungsbereichs 14 des Sensorelements 12 anstatt des Deckelelements 13 vorgesehen sein. Ferner können gemäß einer zusätzlichen Ausführungsform die Verbindungsbereiche sowohl des Deckelelements 13 als auch des Sensorelements 12 mit einer Verbindungsmittel-Aufnahmestruktur versehen sein.

## Patentansprüche

1. Sensor (10), insbesondere mikromechanischer Sensor, mit einem Sensorelement (12), an dem ein Deckelelement (13) mittels eines Verbindungsmittels(15) unter hermetischem Abschluss befestigt ist, wobei wenigstens eines der zwei Elemente (12,13) eine zum anderen Element (12,13) offene Vertiefung(19) aufweist, die von einem Verbindungsbereich (14) umgeben ist, wobei die zwei Elemente(12,13) im Verbindungsbereich (14) unter Ausbildung eines Spalts einander gegenüberliegen, in welchem das Verbindungsmittel (15) angeordnet ist, **dadurch gekennzeichnet, dass** der Verbindungsbereich (14) in Bezug auf seine Mittellinie (23) zur Vertiefung (19) versetzt mindestens eine Verbindungsmittel-Aufnahmestruktur (20) aufweist, die in Form mindestens einer parallel oder etwa parallel zum Rand (17) der Vertiefung (19) verlaufenden Ausnehmung (21) angeordnet und mit einem Teil des Verbindungsmittels (15) aufgefüllt ist, wobei im Spalt in Richtung der Vertiefung (19) hin das Verbindungsmittel (15) derart angebracht ist, dass es den Spalt höchstens bis zum Rand (17) ausfüllt.

2. Sensor nach Anspruch 1, **dadurch gekennzeichnet, dass** das Verbindungsmittel (15) auf dem Verbindungsbereich (14) des Deckelelements (13) angeordnet ist.

3. Sensor nach einem der vorherigen Ansprüche, **dadurch gekennzeichnet, dass** die Verbindungsmittel-Aufnahmestruktur (20) als mindestens eine Aufnahmenut (21) ausgebildet ist.

4. Sensor nach Anspruch 3, **dadurch gekennzeichnet, dass** die Ausnehmung (21) im Querschnitt V-förmig ausgebildet ist.

5. Sensor nach einem der Anspruch 3 oder 4, **dadurch gekennzeichnet, dass** mindestens zwei parallel Ausnehmungen (21) vorgesehen sind.

6. Sensor nach einem der vorherigen Ansprüche, **dadurch gekennzeichnet, dass** das Verbindungsmittel (15) Glaslot ist.

7. Verfahren zur Herstellung eines Sensors (10), insbesondere eines mikromechanischen Sensors, mit den Verfahrensschritten:
Herstellen eines Sensorelements(12) und eines Deckelelements(13), wobei wenigstens eines der zwei Elemente (12,13) eine Vertiefung(19) aufweist, die von einem Verbindungsbereich (14) umgeben ist, und wobei auf dem Verbindungsbereich (14) wenigstens eines der zwei Elemente(12,13) ein Verbindungsmittel(15) aufgetragen wird;
Positionieren des Deckelelements(13) gegenüber dem Sensorelement(12), so dass die Vertiefung(19) zum anderen Element (12,13) offen ist und sich im Verbindungsbereich (14) zwischen den zwei Elementen(12,13) ein die Vertiefung (19) umgebender Spalt bildet, in welchem das Verbindungsmittel (15) angeordnet wird;
gegenseitiges Annähern der zwei Elemente(12,13), so dass sich das Verbindungsmittel (15) im Spalt ausbreitet;
**dadurch gekennzeichnet, dass** eine Verbindungsmittel-Aufnahmestruktur (20) in Form einer parallel zum Rand (17) der Vertiefung (19) verlaufenden Ausnehmung (21) im Verbindungsbereich (14) in Bezug auf dessen Mittellinie (23) zur Vertiefung (19) versetzt angebracht wird und
dass das Verbindungsmittel (15) in Bezug auf die Mittellinie (23) von der Vertiefung (19) weg versetzt auf den Verbindungsbereich (14) aufgetragen wird und ein die Höhe des Spalts bestimmender Abstand der beiden Elemente (12,13) durch deren Annähern derart hergestellt wird, dass das sich durch Kompression im Spalt in Richtung der Vertiefung (19) ausbreitenden Verbindungsmittels (15) vom Spaltvolumen vollständig aufgenommen wird, wobei die Ausnehmung (21) einen Teil dieses Verbindungsmittels (15) aufnimmt.

## Claims

1. Sensor (10), in particular a micromechanical sensor, having a sensor element (12), to which a cap element (13) is fastened by means of a bonding substance (15) to create a hermetic seal, at least one of the two elements (12, 13) having an indentation (19) which is open to the other element (12, 13) and is surrounded by a bonding area (14), the two elements (12, 13) lying opposite each other in the bonding area (14) to form a gap, in which the bonding substance (15) is arranged, **characterized in that** the bonding area (14) has, offset from the indentation (19) with respect to its centre line (23), at least one bonding substance receiving structure (20), which is arranged in the form of at least one recess (21) running parallel or approximately parallel to the edge (17) of the indentation (19) and is filled with part of the bonding substance (15), the bonding substance (15) being provided in the gap in the direction of the indentation (19) in such a way that it fills the gap at most up to the edge (17).

2. Sensor according to Claim 1, **characterized in that** the bonding substance (15) is arranged on the bonding area (14) of the cap element (13).

3. Sensor according to one of the preceding claims, **characterized in that** the bonding substance receiving structure (20) is formed as at least one receiving groove (21).

4. Sensor according to Claim 3, **characterized in that** the recess (21) is formed in a V-shaped manner in cross section.

5. Sensor according to either of Claims 3 and 4, **characterized in that** at least two parallel recesses (21) are provided.

6. Sensor according to one of the preceding claims, **characterized in that** the bonding substance (15) is glass solder.

7. Method for producing a sensor (10), in particular a micromechanical sensor, with the method steps of:
producing a sensor element (12) and a cap element (13), at least one of the two elements (12, 13) having an indentation (19), which is surrounded by a bonding area (14), and a bonding substance (15) being applied to the bonding area (14) of at least one of the two elements (12, 13);
positioning the cap element (13) with respect to the sensor element (12), so that the indentation (19) is open towards the other element (12, 13) and a gap which surrounds the indentation (19) and in which the bonding substance (15) is arranged forms in the bonding area (14) between the two elements (12, 13);
bringing the two elements (12, 13) closer together, so that the bonding substance (15) in the gap spreads;
**characterized in that** a bonding substance receiving structure (20) in the form of a recess (21) running parallel to the edge (17) of the indentation (19) is provided in the bonding area (14), offset from the indentation (19) with respect to its centre line (23), and
**in that** the bonding substance (15) is applied to the bonding area (14) such that it is offset away from the indentation (19) with respect to the centre line (23) and a distance between the two elements (12, 13) that determines the height of the gap is established by bringing the two said elements together in such a way that the bonding substance (15) spreading in the gap in the direction of the indentation (19) as a result of compression is received completely by the volume of the gap, the recess (21) receiving part of this bonding substance (15).

## Revendications

1. Capteur (10) notamment capteur micromécanique comportant un élément de capteur (12) auquel est fixé un élément de couverture (13) par l'intermédiaire d'un moyen de liaison (15) pour une fermeture hermétique,
au moins l'un des deux éléments (12, 13) ayant une cavité (19) ouverte en direction de l'autre élément (12, 13), cette cavité étant entourée par une zone de liaison (14),
les deux éléments (12, 13) se faisant face dans la zone de liaison (14) en formant un intervalle dans lequel se trouve le moyen de liaison (15)
**caractérisé en ce que**
la zone de liaison (14) est décalée vers la cavité (19) par rapport à sa ligne médiane (23) en ayant au moins une structure de réception (20) du moyen de liaison, sous la forme d'au moins une cavité (21) parallèle ou sensiblement parallèle au bord (17) de la cavité (19) et remplie avec une partie du moyen de liaison (15),
l'intervalle dans la direction de la cavité (19) recevant le moyen de liaison (15) pour être rempli au maximum jusqu'au bord (17).

2. Capteur selon la revendication 1,
**caractérisé en ce que**
le moyen de liaison (15) est prévu sur la zone de liaison (14) de l'élément de couverture (13).

3. Capteur selon l'une des revendications précédentes,
**caractérisé en ce que**
la structure de réception (20) du moyen de liaison est réalisée au moins sous la forme d'une rainure de réception (21).

4. Capteur selon la revendication 3,
**caractérisé en ce que**
la cavité (21) a une section en forme de V.

5. Capteur selon l'une des revendications 3 ou 4,
**caractérisé par**
au moins deux cavités parallèles (21).

6. Capteur selon l'une des revendications précédentes,
**caractérisé en ce que**
le moyen de liaison (15) est de la soudure de verre.

7. Procédé de fabrication d'un capteur (10), notamment d'un capteur micromécanique comprenant les étapes suivantes :
- fabrication d'un élément de capteur (12) et d'un élément de couverture (13), au moins l'un des deux éléments (12, 13) ayant une cavité (19) entourée par une zone de liaison (14) et dans la zone de liaison (14) au moins l'un des deux éléments (12, 13) porte un moyen de liaison (15),
- positionnement de l'élément de couverture (13) par rapport à l'élément de capteur (12) pour que la cavité (19) soit ouverte en direction de l'autre élément (12, 13) et qu'il se forme un intervalle entourant la cavité (19) dans la zone de liaison (14) entre deux éléments (12, 13), intervalle dans lequel se trouve le moyen de liaison (15),
- rapprochement des deux éléments (12, 13) l'un par rapport à l'autre pour que le moyen de liaison (15) se déploie dans l'intervalle,
**caractérisé par**
une structure de réception (20) du moyen de liaison sous la forme d'une cavité (21) parallèle au bord (17) de la cavité (19) dans la zone de liaison (14) en étant décalée vers la cavité (19) par rapport à sa ligne médiane (23),
le moyen de liaison (15) est écarté par rapport à la ligne médiane (23) par rapport à la cavité (19) en étant appliqué sur la zone de liaison (14) et la distance des deux éléments (12, 13) qui définit la hauteur de l'intervalle est assurée par le rapprochement de façon que par compression du moyen de liaison (15) déployé dans l'intervalle en direction de la cavité (19), le moyen de liaison (15) qui s'étale soit complètement reçu par le volume de l'intervalle, la cavité (21) recevant une partie de ce moyen de liaison.
